# EUROPEAN PATENT APPLICATION

(11) **EP 2 546 611 A1**
(43) Date of publication of application: **16.01.2013**
(21) Application number: 11753156.6
(22) Date of filing: 17.02.2011
(51) Int. Cl.: G01D 5/245, H01L 27/22, H01L 43/08

(54) **MAGNETIC SENSOR AND MAGNETIC ENCODER**

(30) Priority: 12.03.2010 JP 2010056157
(71) Applicant: Alps Electric Co., Ltd., Tokyo 145-8501 (JP)
(72) Inventor: NAKAMURA, Tokuo, Tokyo 145-8501 (JP)
(74) Representative: Wohlfrom, Karl-Heinz
(86) International application number: PCT/JP2011/053344
(87) International publication number: WO 2011/111494

(57) **Abstract**

To obtain output signals where the phases of the output signals of two magnetic detector elements have a desired phase relationship with each other, without the size of a single sensor package being increased even if the two magnetic detector elements are accommodated within the sensor package. A magnetic sensor (3) includes two magnetic detector elements (11, 12) provided so as to face the outer circumference portion of a rotating magnet (8) in which magnetic poles adjacent to each other in a circumferential direction are magnetized with the polarities thereof being different from each other, and the two magnetic detector elements (11, 12) are disposed in a single sensor package (10) with the sensitivity axis directions of the two magnetic detector elements (11, 12) being different from each other so that the phases of output signals output from the two magnetic detector elements (11, 12) have a desired phase relationship with each other.

## Description

### Technical Field

The present invention relates to a magnetic sensor utilizing a magnetic detector element and a magnetic encoder equipped therewith.

### Background Art

In the past, as this type of magnetic encoder, there has been a magnetic encoder that detects the rotation direction of a rotating magnet using two magnetic sensors including a single magnetic detector element (refer to PTL 1). In this magnetic encoder, in the rotation direction of the rotating magnet in which a north pole and a south pole are alternately magnetized, two magnetic sensors are disposed so that the output signals of the two magnetic detector elements are out of phase with each other by a predetermined phase. In addition, on the basis of a phase shifts between the output signals of the individual magnetic detector elements, the magnetic encoder detects the rotation direction of the rotating magnet.

### Citation List

### Patent Literature

PTL 1: Japanese Unexamined Patent Application Publication No. 2001-201364

### Summary of Invention

### Technical Problem

Incidentally, in recent years, a magnetic detector element (GMR element) utilizing a giant magnetoresistance effect (GMR effect) has been used for a magnetic encoder, and there has been a magnetic sensor used for applied detection, which utilizes this magnetic encoder. In addition, the downsizing of a unit accommodating a magnetic sensor or a rotating magnet has been requested, and to accommodate a plurality of magnetic detector elements within a single sensor package has been developed.

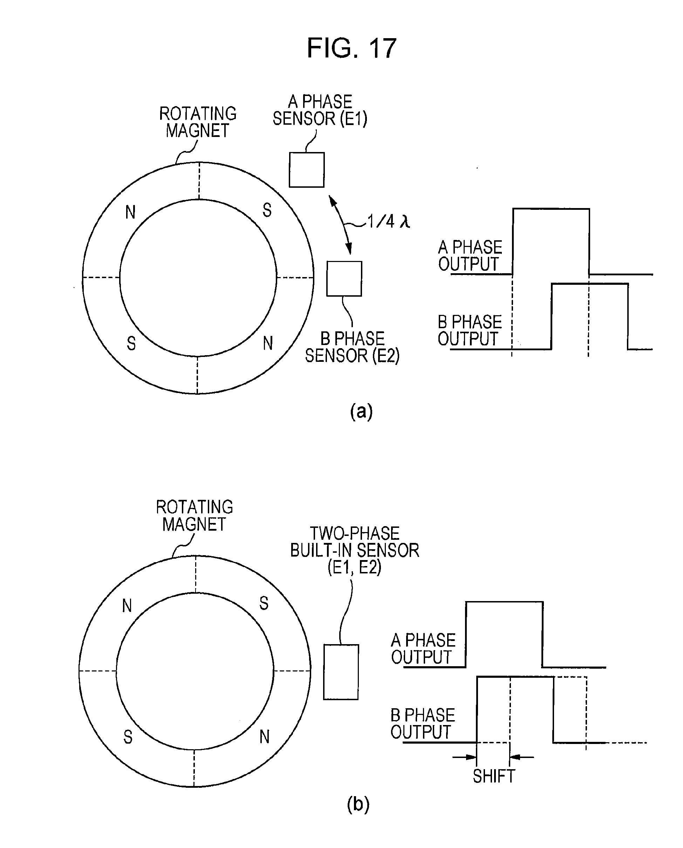

However, when a phase relationship between two output signals (an A phase output and a B phase output) has been adjusted using a positional relationship between individual magnetic detector elements E1 and E2 (Fig. 17(a)) in such a way as in the past and the magnetic detector elements E1 and E2 have been accommodated in the single sensor package, the phase relationship between the output signals of the individual magnetic detector elements E1 and E2 has been shifted (Fig. 17(b)), and there has occurred a problem that it is hard to detect the rotation direction of the rotating magnet with accuracy. In addition, since there is a constraint on the size or the like of an IC accommodated in the sensor package with the downsizing of the magnetic sensor being requested, there is a limit on adjusting the physical placement of the individual magnetic detector elements E1 and E2 within the sensor package so that the output signals have a desired phase difference therebetween.

In view of such a regard, the present invention is made, and an object thereof is to provide a magnetic sensor capable of obtaining an output signal where the phases of the output signals of a plurality of magnetic detector elements have a desired phase relationship with one another, without the size of a single sensor package being increased even if the plural magnetic detector elements are accommodated within the sensor package, and a magnetic encoder equipped with the magnetic sensor.

### Solution to Problem

A magnetic sensor of the present invention is a magnetic sensor including first and second magnetic detector elements provided so as to face an outer circumference portion of a rotating magnet in which magnetic poles adjacent to each other in a circumferential direction are magnetized with polarities thereof being different from each other, wherein the first and second magnetic detector elements are disposed in a single sensor package with sensitivity axis directions of the individual magnetic detector elements being different from each other so that phases of output signals output from the first and second magnetic detector elements have a desired phase relationship with each other.

According to this configuration, the sensitivity axis directions of the individual magnetic detector elements are disposed with being different (shifted) from each other so that the phases of the individual output signals have a desired phase relationship with each other. Therefore, even if the two magnetic detector elements are accommodated within the single sensor package, it is possible to obtain the output signals of the individual magnetic detector elements having a desired phase relationship with one another without the size of the sensor package being increased.

In the above-mentioned magnetic sensor, the rotating magnet includes four poles whose magnetization pitches are equal to one another, and a sensitivity axis direction of the other magnetic detector element is caused to be perpendicular to a sensitivity axis direction of one magnetic detector element in a same plane.

The above-mentioned magnetic sensor includes a third magnetic detector element provided so as to face the outer circumference portion of the rotating magnet, wherein the first, second, and third magnetic detector elements are disposed in the single sensor package with sensitivity axis directions of the individual magnetic detector elements being different from each other so that phases of output signals output from the first, second, and third magnetic detector elements have a desired phase relationship with each other.

In this case, it is desirable that the first, second, and third magnetic detector elements are disposed so that the sensitivity axis directions of the individual magnetic detector elements are shifted from each other by 30 degrees, 60 degrees, or 120 degrees in a same plane.

In the above-mentioned magnetic sensor, the first and second magnetic detector elements are magnetoresistance effect elements.

A magnetic encoder of the present invention includes a rotating magnet in which magnetic poles adjacent to each other in a circumferential direction are magnetized with polarities thereof being different from each other, and a magnetic sensor including first and second magnetic detector elements provided so as to face an outer circumference portion of the rotating magnet, wherein the first and second magnetic detector elements are disposed in a single sensor package with sensitivity axis directions of the individual magnetic detector elements being different from each other so that phases of output signals output from the first and second magnetic detector elements have a desired phase shift.

According to this configuration, the sensitivity axis directions of the individual magnetic detector elements are disposed with being different (shifted) from each other so that the phases of the individual output signals have a desired phase relationship with each other. Therefore, even if the two magnetic detector elements are accommodated within the single sensor package, it is possible to obtain the output signals of the individual magnetic detector elements having a desired phase relationship with one another and it is possible to detect the rotation direction of the rotating magnet with accuracy, without the size of the sensor package being increased.

In the above-mentioned magnetic encoder, the magnetic sensor includes a third magnetic detector element provided so as to face the outer circumference portion of the rotating magnet, wherein the first, second, and third magnetic detector elements are disposed in the single sensor package with sensitivity axis directions of the individual magnetic detector elements being different from each other so that phases of output signals output from the first, second, and third magnetic detector elements have a desired phase relationship with each other.

### Advantageous Effects of Invention

According to the present invention, even if a plurality of magnetic detector elements are accommodated within a single sensor package, it is possible to obtain an output signal where the phases of the output signals of the plural magnetic detector elements have a desired phase relationship with each other, without the size of the sensor package being increased.

### Brief Description of Drawings

[Fig. 1] Fig. 1 is a diagram schematically illustrating a magnetic encoder according to a first embodiment of the present invention.
[Fig. 2] Fig. 2 is a diagram illustrating a configuration of a magnetic sensor according to the present embodiment.
[Fig. 3] Fig. 3 is a diagram for explaining a manufacturing method for a magnetic detector element according to the present embodiment.
[Fig. 4] Fig. 4 is a diagram for explaining a manufacturing method for a magnetic detector element according to the present embodiment.
[Fig. 5] Fig. 5 is a diagram for explaining an effect of a magnetic encoder according to the present embodiment.
[Fig. 6] Fig. 6 is a diagram schematically illustrating a magnetic encoder according to a second embodiment of the present invention.
[Fig. 7] Fig. 7 is a diagram illustrating a configuration of a magnetic sensor according to the present embodiment.
[Fig. 8] Fig. 8 is a diagram for explaining a manufacturing method for a magnetic detector element according to the present embodiment.
[Fig. 9] Fig. 9 is a diagram for explaining a manufacturing method for a magnetic detector element according to the present embodiment.
[Fig. 10] Fig. 10 is a diagram for explaining a manufacturing method for a magnetic detector element according to the present embodiment.
[Fig. 11] Fig. 11 is a diagram for explaining an effect of a magnetic encoder according to the present embodiment.
[Fig. 12] Fig. 12 is a pattern diagram illustrating examples of brushless motors into which magnetic sensors according to the present embodiment and a comparative example are applied.
[Fig. 13] Fig. 13 is a diagram illustrating an example of a signal output from a magnetic sensor according to the present embodiment.
[Fig. 14] Fig. 14(a) is a diagram illustrating a relationship between a magnetic flux density of a magnetic sensor and a rotor rotational angle of a rotating magnet (rotor magnet) according to an embodiment, and Fig. 14(b) is a diagram illustrating a relationship between a magnetizing field vector angle of a magnetic sensor and a rotor rotational angle according to an embodiment.
[Fig. 15] Fig. 15(a) illustrates an output signal from each magnetic detector element in a magnetic sensor according to an embodiment, and Fig. 15(b) illustrates a signal into which the signal illustrated in Fig. 15(a) is digital-converted.
[Fig. 16] Fig. 16 is a diagram illustrating an example of an output signal from each magnetic detector element in a magnetic sensor according to an embodiment.
[Fig. 17] Fig. 17 is a diagram for explaining a problem of the present invention.

### Description of Embodiments

Hereinafter, the embodiments of the present invention will be described in detail with reference to accompanying drawings. A magnetic encoder including a magnetic sensor according to the embodiment of the present invention detects the rotation of a rotating magnet serving as a magnetic flux generation source, on the basis of the phase shifts of the sensor outputs of a plurality of magnetic detector elements.

### (First Embodiment)

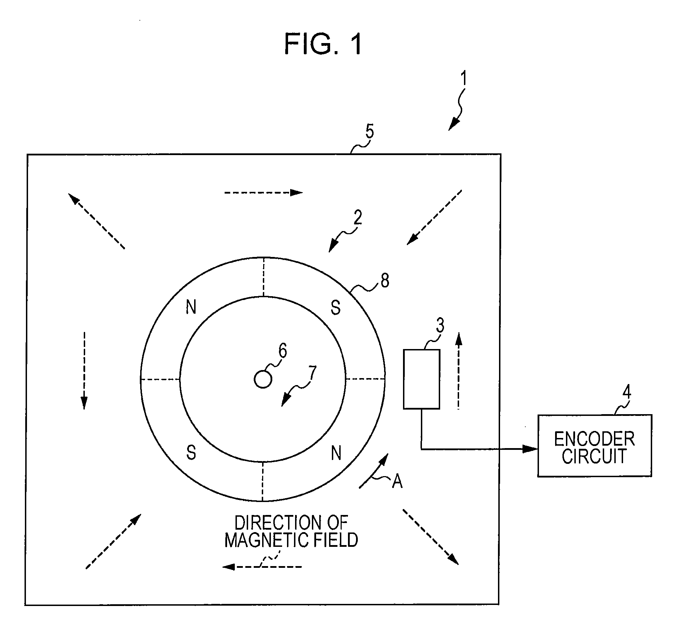

Fig. 1 is a diagram schematically illustrating a magnetic encoder including a magnetic sensor according to a first embodiment of the present invention. A magnetic encoder 1 includes a rotating body 2, a magnetic sensor 3, and an encoder circuit 4. In addition, Fig. 1 will be described assuming that a rotating magnet 8 rotates in a direction (arrow A direction) opposite to a clockwise direction. In addition, arrows indicated by dotted lines in Fig. 1 indicate the directions of the magnetic field of the rotating magnet 8.

The rotating body 2 is provided on a base 5, and the rotation axis 6 of the rotating body 2 is rotatably supported by a bearing (the illustration thereof is omitted) fixed on the base 5. The base 5, the bearing, and the rotation axis 6 are formed using nonmagnetic material such as synthetic resin material or the like. The rotating body 2 is formed in a thin disk shape and fixed to the rotation axis 6, and includes an inner circumference portion 7 formed using nonmagnetic material and a rotating magnet 8 provided in the outer circumference of the inner circumference portion 7. In the rotating magnet 8, magnetic poles adjacent to each other in a circumferential direction are magnetized with the polarities thereof being different from each other. In the present embodiment, the rotating magnet 8 includes a rotating magnet including four poles whose magnetization pitches are equal to one another. On the base 5, at a position facing the outer circumference surface of the rotating magnet 8, the magnetic sensor 3 is fixedly set up so as to be adjacent to the outer circumference surface.

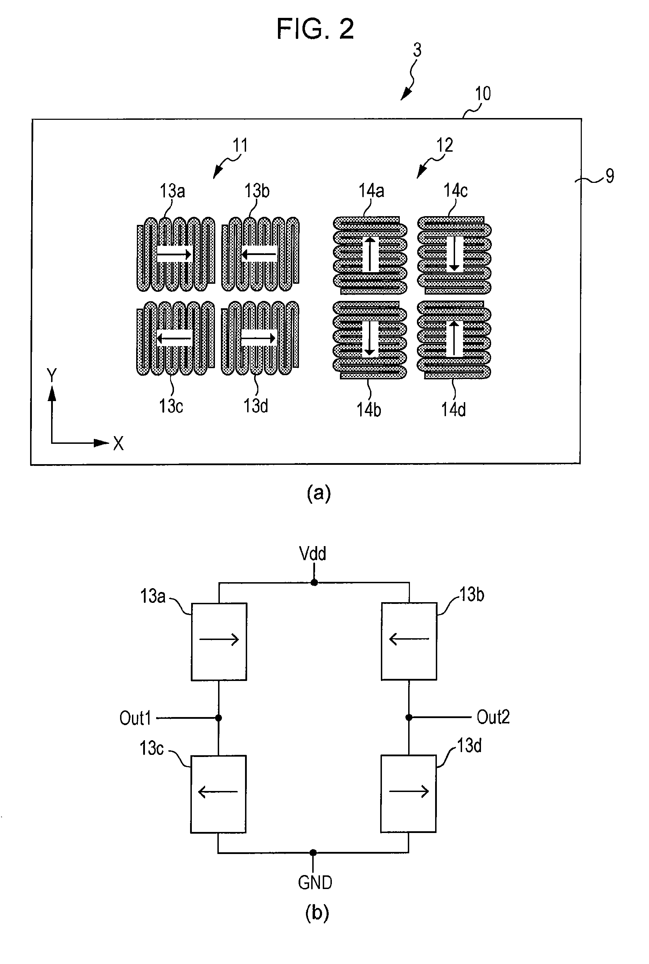

Fig. 2 is a diagram illustrating the configuration of the magnetic sensor 3, Fig. 2(a) is a plan pattern diagram illustrating the disposition relationship of the magnetic sensor, and Fig. 2(b) is a magnetic detection bridge circuit diagram in Fig. 2(a). As illustrated in Fig. 2(a), in the magnetic sensor 3, a plurality of magnetic detector elements 11 and 12 (two in the present embodiment) having a same film configuration are mounted on a substrate 9 so as to be adjacent to each other, and these magnetic detector elements 11 and 12 are accommodated within a single sensor package 10. Here, as the magnetic detector elements 11 and 12, it is desirable to use a magnetoresistance effect element such as a GMR (Giant Magneto Resistive) element, a TMR (Tunnel Magneto Resistance) element, or the like, which has a high output and a high sensitivity characteristic.

The magnetic detector element 11 includes a bridge circuit in which four magnetoresistance effect elements 13a to 13d are bridge-connected. Each magnetoresistance effect element 13 is formed in a shape (meander shape) in which a plurality of belt-like elongated patterns (stripes), disposed so that the longitudinal directions thereof are parallel to one another, are folded. In each magnetoresistance effect element 13 formed in this meander shape, usually a sensitivity axis direction (Pin direction) is a direction (stripe width direction) (an X direction illustrated in Fig. 2(a)) perpendicular to the longitudinal direction (stripe longitudinal direction) of the elongated pattern.

In the same way, the magnetic detector element 12 includes a bridge circuit in which four magnetoresistance effect elements 14a to 14d are bridge-connected. Each magnetoresistance effect element 14 is formed in a shape (meander shape) in which a plurality of belt-like elongated patterns (stripes), disposed so that the longitudinal directions thereof are parallel to one another, are folded. In each magnetoresistance effect element 14 formed in this meander shape, usually a sensitivity axis direction (Pin direction) is a direction (stripe width direction) (a Y direction illustrated in Fig. 2(a)) perpendicular to the longitudinal direction (stripe longitudinal direction) of the elongated pattern.

Using Fig. 2(b), a magnetic detection bridge circuit will be described. While here a magnetic detection bridge circuit in the magnetic detector element 11 will be cited as an example and described, the magnetic detector element 12 also has the same circuit configuration. In the magnetic detection bridge circuit illustrated in Fig. 2(b), a power source Vdd is connected to a connection point between the magnetoresistance effect element 13a and the magnetoresistance effect element 13b, and a ground (GND) is connected to a connection point between the magnetoresistance effect element 13c and the magnetoresistance effect element 13d. Furthermore, in this magnetic field detection bridge circuit, an output Outl is extracted from a connection point between the magnetoresistance effect element 13a and the magnetoresistance effect element 13c, and another output Out2 is extracted from a connection point between the magnetoresistance effect element 13b and the magnetoresistance effect element 13d.

The two magnetic detector elements 11 and 12 configured in this way are disposed with the sensitivity axis directions of the individual magnetic detector elements 11 and 12 being different (shifted) from each other so that the phases of output signals output from the individual magnetic detector elements 11 and 12 have a desired phase relationship with each other. In the present embodiment, the magnetic detector elements 11 and 12 are disposed so that the sensitivity axis direction of the magnetic detector element 12 is perpendicular to the sensitivity axis direction of the magnetic detector element 11 in a same plane. Accordingly, it is possible to obtain the output signals of the individual magnetic detector elements 11 and 12 having a desired phase relationship with each other. In the present embodiment, it is possible to obtain output signals out of phase with each other by 90 degrees in the phase relationship between the output signals of the individual magnetic detector elements 11 and 12. In addition, while, in the present embodiment, in order to obtain output signals having a phase difference of 90 degrees, the sensitivity axis directions of the two magnetic detector elements 11 and 12 are disposed so as to be perpendicular to each other, the phase relationship is not limited to this configuration. For example, the sensitivity axis directions of three magnetic detector elements may be disposed so as to be shifted from each other by 30 degrees, and it may be possible to obtain output signals out of phase with each other by 30 degrees in the phase relationship between the output signals of the individual magnetic detector elements.

On the basis of the phase shift between the output signals of the two magnetic detector elements 11 and 12, the encoder circuit 4 detects the rotation of the rotating magnet 8. Specifically, the encoder circuit 4 acquires an output signal from the magnetic detector element 11 subjected to the influence of the flow of a magnetizing field (the direction of the magnetic field) associated with the rotation of the rotating magnet 8, and next acquires an output signal, out of phase with the former output signal by 90 degrees, from the magnetic detector element 12 subjected to the influence of the flow of a magnetizing field (the direction of the magnetic field). In addition, from these two output signals having a phase difference of 90 degrees, the encoder circuit 4 detects the rotation of the rotating magnet 8.

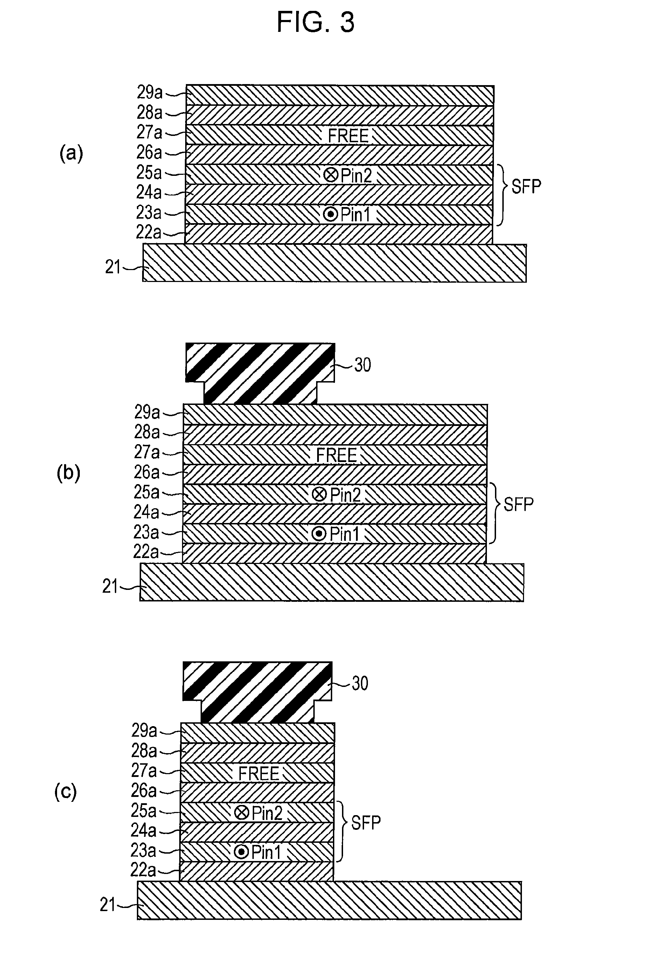

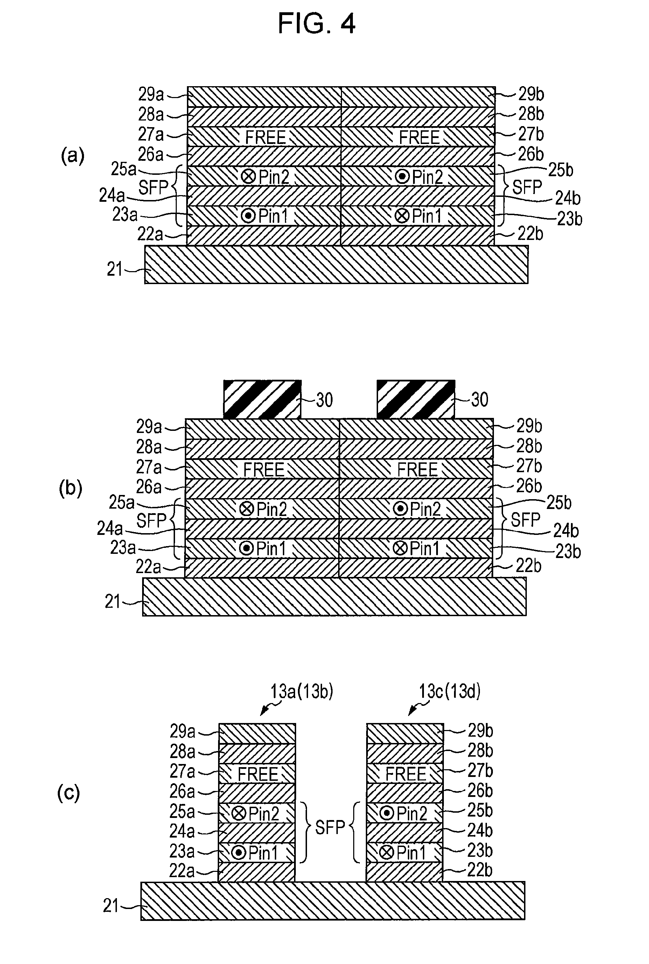

Next, using Fig. 3 and Fig. 4, the film configuration of the magnetoresistance effect element and the manufacturing method therefor will be described. The film configuration of the magnetoresistance effect element used in the present invention is illustrated in Fig. 3(a), for example. Namely, as illustrated in Fig. 3(a), the magnetoresistance effect element has a laminated structure provided in a substrate 21. In addition, in Fig. 3(a), for ease of explanation, a foundation layer and the like other than the magnetoresistance effect element are omitted in the substrate 21, and illustration is performed. The magnetic detector element includes a seed layer 22a, a first ferromagnetic film 23a, an antiparallel coupling film 24a, a second ferromagnetic film 25a, a nonmagnetic intermediate film 26a, soft magnetic free layers (free magnetic layers) 27a and 28a, and a protective layer 29a.

The seed layer 22a is formed using NiFeCr, Cr, or the like. The protective layer 20 is formed using Ta or the like. In addition, in the above-mentioned laminated structure, a foundation layer formed, for example, using nonmagnetic material such as at least one element of Ta, Hf, Nb, Zr, Ti, Mo, and W, or the like, may be provided between the substrate 21 and the seed layer 22a.

In this magnetic detector element, the first ferromagnetic film 23a and the second ferromagnetic film 25a are antiferromagnetically coupled to each other through the antiparallel coupling film 24a, and a so-called self-pinned-type ferromagnetic fixed layer (SFP: Synthetic Ferri Pinned layer) is configured.

In this ferromagnetic fixed layer, the thickness of the antiparallel coupling film 24a is set to 0.3 nm to 0.45 nm, or 0.75 nm to 0.95 nm, and hence it is possible to cause a strong antiferromagnetic coupling to occur between the first ferromagnetic film 23a and the second ferromagnetic film 25a.

It is desirable that the first ferromagnetic film 23a is formed using CoFe alloy including Fe of 40 atomic% to 80 atomic%. This is because the CoFe alloy in this composition range has a large coercive force and it is possible to stably maintain magnetization against an external magnetizing field. In addition, it is desirable that the second ferromagnetic film 25a is formed using CoFe alloy including Fe of 0 atomic% to 40 atomic%. This is because the CoFe alloy in this composition range has a small coercive force and is easily magnetized in a direction antiparallel to (direction different by 180 degrees from) a direction in which the first ferromagnetic film 23a is preferentially magnetized. As a result, it is possible to further enlarge Hk. In addition, by limiting the second ferromagnetic film 25a to this composition range, it is possible to enlarge the resistance change rate of the magnetoresistance effect element.

It is desirable that, in the first ferromagnetic film 23a and the second ferromagnetic film 25a, a magnetizing field is applied in the stripe width direction of the meander shape during the film formation thereof and induced magnetic anisotropy is added to the first ferromagnetic film 23a and the second ferromagnetic film 25a after the film formation. Accordingly, the both films 23a and 25a turn out to be magnetized antiparallel to the stripe width direction. In addition, since the magnetization directions of the first ferromagnetic film 23a and the second ferromagnetic film 25a are determined on the basis of the application direction of a magnetizing field at the time of the film formation of the first ferromagnetic film 23a, it is possible to form a plurality of magnetoresistance effect elements having different ferromagnetic fixed layers whose magnetization directions are different from one another, on a same substrate, by changing the application direction of a magnetizing field at the time of the film formation of the first ferromagnetic film 23a.

The antiparallel coupling film 24a in a ferromagnetic fixed layer is formed using Ru or the like. In addition, the soft magnetic free layers (free layers) 27a and 28a are formed using magnetic material such as CoFe alloy, NiFe alloy, CoFeNi alloy, or the like. In addition, the nonmagnetic intermediate layer 26a is formed using Cu or the like. In addition, it is desirable that, in the soft magnetic free layers 27a and 28a, a magnetizing field is applied in the stripe longitudinal direction of the meander shape during the film formation thereof and induced magnetic anisotropy is added to the soft magnetic free layers 27a and 28a after the film formation. Accordingly, in the magnetoresistance effect element, resistance linearly changes with respect to an external magnetizing field (magnetizing field from a current to be measured) in the stripe width direction, and it is possible to reduce hysteresis. In such a magnetoresistance effect element, owing to the ferromagnetic fixed layer, the nonmagnetic intermediate layer, and the soft magnetic free layer, a spin-valve configuration is adopted.

For example, as an example of the film configuration of the magnetoresistance effect element used in the magnetic balance current sensor of the present invention, there are NiFeCr (the seed layer: 5 nm)/70 FeCo (the first ferromagnetic film: 1.65 nm)/Ru (the antiparallel coupling film: 0.4 nm)/90 CoFe (the second ferromagnetic film: 2 nm)/Cu (the nonmagnetic intermediate layer: 2.2 nm)/90 CoFe (the soft magnetic free layer: 1 nm)/NiFe (the soft magnetic free layer: 7 nm)/Ta (the protective layer: 5 nm).

Figs. 3(a) to 3(c) and Figs. 4(a) to 4(c) are diagrams for explaining a manufacturing method for a magnetoresistance effect element in a current sensor according to the embodiment of the present invention. Here, a case in which the magnetoresistance effect element 13 is manufactured will be cited as an example and described. First, as illustrated in Fig. 3(a), on the substrate 21, the seed layer 22a, the first ferromagnetic film 23a, the antiparallel coupling film 24a, the second ferromagnetic film 25a, the nonmagnetic intermediate film 26a, the soft magnetic free layers (free magnetic layers) 27a and 28a, and the protective layer 29a are sequentially formed. During the film formation of the first ferromagnetic film 23a and the second ferromagnetic film 25a, a magnetizing field is applied in the stripe width direction of the meander shape. In Fig. 3, as for the first ferromagnetic film 23a, the applied-magnetizing field direction is a direction headed from the far side of the plane of paper to the near side thereof, and as for the second ferromagnetic film 25a, the applied-magnetizing field direction is a direction headed from the near side of the plane of paper to the far side thereof. In addition, during the film formation of the soft magnetic free layers (free magnetic layers) 27a and 28a, a magnetizing field is applied in the stripe longitudinal direction of the meander shape.

Next, as illustrated in Fig. 3(b), a resist layer 30 is formed on the protective layer 29a, and owing to photolithography and etching, the resist layer 30 is caused to remain on a region on the magnetoresistance effect element 13a (13b) side. Next, as illustrated in Fig. 3(c), owing to ion milling or the like, an exposed laminated film is removed, and the substrate 21 in a region in which the magnetoresistance effect element 13c (13d) is to be provided is caused to be exposed.

Next, as illustrated in Fig. 4(a), on the exposed substrate 21, a seed layer 22b, a first ferromagnetic film 23b, an antiparallel coupling film 24b, a second ferromagnetic film 25b, a nonmagnetic intermediate film 26b, soft magnetic free layers (free magnetic layers) 27b and 28b, and a protective layer 29b are sequentially formed. During the film formation of the first ferromagnetic film 23b and the second ferromagnetic film 25b, a magnetizing field is applied in the stripe width direction of the meander shape. In Fig. 4, as for the first ferromagnetic film 23b, the applied-magnetizing field direction is a direction headed from the near side of the plane of paper to the far side thereof, and as for the second ferromagnetic film 25b, the applied-magnetizing field direction is a direction headed from the far side of the plane of paper to the near side thereof. In addition, during the film formation of the soft magnetic free layers (free magnetic layers) 27b and 28b, a magnetizing field is applied in the stripe longitudinal direction of the meander shape.

Next, as illustrated in Fig. 4(b), the resist layer 30 is formed on the protective layers 29a and 29b, and owing to photolithography and etching, the resist layer 30 is caused to remain on the forming regions of the magnetoresistance effect elements 13a and 13c. Next, as illustrated in Fig. 4(c), owing to ion milling or the like, an exposed laminated film is removed, and the magnetoresistance effect elements 13a and 13c are formed. In addition, the processing illustrated in Fig. 3 and Fig. 4 is repeated in the same way, and the magnetoresistance effect elements 13b and 13d are formed.

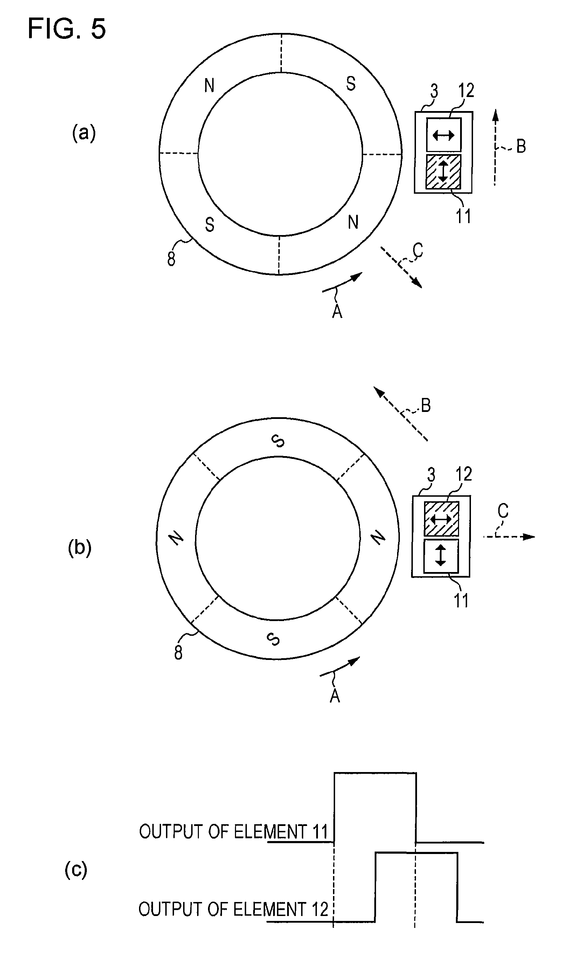

Next, using Fig. 5, the effect of the magnetic encoder 1 according to the present embodiment will be described. Fig. 5 is a pattern diagram for explaining the effect of the magnetic encoder 1 according to the present embodiment. Figs. 5(a) and 5(b) illustrate a relationship between the direction of the magnetic field of the rotating magnet 8 and the sensitivity axis directions of the magnetic detector elements 11 and 12, and Fig. 5(c) illustrates a phase relationship between the output signals of the magnetic detector elements 11 and 12 in Figs. 5(a) and 5(b). While, in Fig. 5, the magnetic sensor 3 is disposed so that the sensitivity axis direction of the magnetic detector element 11 corresponds to the up-and-down direction of the plane of paper and the sensitivity axis direction of the magnetic detector element 12 corresponds to the crosswise direction of the plane of paper, the magnetic sensor 3 is not limited to this configuration.

When the rotating magnet 8 has rotated in an arrow A direction and is located at a position in Fig. 5(a), the magnetic detector element 11 having the sensitivity axis direction in the same direction as the direction (arrow B direction) of a magnetic field is most strongly subjected to the influence of the magnetizing field with this rotation, and the angle (magnetizing field angle) of the magnetization direction of the free magnetic layer with respect to the magnetization direction of the ferromagnetic fixed layer changes. On the basis of this change of the magnetizing field angle, an electrical resistance value changes, and an output signal based on the electrical resistance value according to this change is output to the encoder circuit 4 (Fig. 5(c)). Furthermore, when the rotating magnet 8 has rotated by 45 degrees from the position in Fig. 5(a) in the arrow A direction and is located at a position in Fig. 5(b), the magnetic detector element 12 having the sensitivity axis direction perpendicular to the sensitivity axis direction of the magnetic detector element 11 is most strongly subjected to the influence of the magnetizing field flowing in the direction (arrow C direction) of the magnetic field, and the magnetizing field angle of the magnetization direction of the free magnetic layer with respect to the magnetization direction of the ferromagnetic fixed layer changes. On the basis of this change of the magnetizing field angle, an electrical resistance value changes, and an output signal based on the electrical resistance value according to this change is output to the encoder circuit 4 (Fig. 5(c)). At this time, the output signals from the individual magnetic detector elements 11 and 12 are put into a state in which the output signals are out of phase with each other by 90 degrees. Namely, owing to the Sin wave and Cos wave outputs of the magnetic detector elements 11 and 12, a two-phase output with a 90-degree phase difference and a Duty ratio of 50% is obtained. In the encoder circuit 4, from the phase relationship of the output signal of the magnetic detector element 12, out of phase with the phase of the output signal from the magnetic detector element 11 by 90 degrees, the rotation direction of the rotating magnet 8 is detected. Namely, as illustrated in Fig. 5(c), in the encoder circuit 4, after the output signal output from the magnetic detector element 11 has been obtained, the output signal output from the magnetic detector element 12, out of phase with the output signal of the magnetic detector element 11 by 90 degrees, is obtained. Therefore, the rotation direction of the rotating magnet 8 is detected.

In the past, in order to cause the output signals of individual magnetic detector elements to have a 90-degree phase difference with each other, two magnetic detector elements E1 and E2 has been fixedly set up at a position where the output signals thereof have been shifted from each other by a 1 / 4 λ wave length (Fig. 17(a)). Therefore, when, with a request for the downsizing of the magnetic encoder, these individual magnetic detector elements E1 and E2 are simply accommodated within the single sensor package, the above-mentioned phase relationship turns out to be deteriorated (Fig. 17(b)). On the other hand, in the magnetic sensor 3 according to the present embodiment, the two magnetic detector elements 11 and 12 are disposed on the same substrate 9 so that the sensitivity axis directions thereof are caused to be perpendicular to each other in response to the phase difference of 90 degrees between the desired output signals. Therefore, even if the magnetic detector elements 11 and 12 are accommodated within the single sensor package 10, it is possible to obtain the output signals of the individual magnetic detector elements 11 and 12 having the desired phase difference, and hence it is possible to downsize the magnetic encoder 1.

In this way, in the present embodiment, the sensitivity axis directions of the individual magnetic detector elements 11 and 12 are disposed with being different (shifted) from each other so that the phases of the individual output signals have a desired phase relationship with each other. Therefore, even if the two (plural) magnetic detector elements 11 and 12 are accommodated within the single sensor package 10, it is possible to obtain the output signals of the individual magnetic detector elements 11 and 12 having the desired phase relationship with each other without increasing the size of the sensor package 10, and hence it is possible to detect the rotation of the rotating magnet 8 with accuracy. Namely, from the output signal from the magnetic detector element 11 and the output signal from the magnetic detector element 12 out of phase with the output signal of the magnetic detector element 11 by a predetermined phase, it is possible to detect the rotation direction of the rotating magnet 8 with accuracy.

### (Second Embodiment)

Next, a second embodiment of the present invention will be described. Compared with the magnetic encoder 1 according to the above-mentioned first embodiment, a magnetic encoder according to the second embodiment of the present invention is different only in the configuration of a magnetic sensor. Accordingly, in particular, the difference will be only described, a same symbol will be used with respect to a same configuration, and the repetitive description will be omitted.

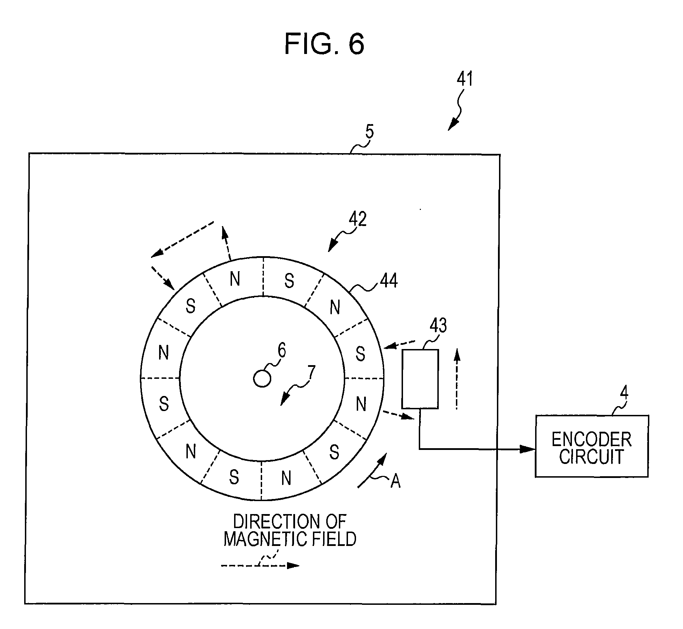

Fig. 6 is a diagram schematically illustrating the magnetic encoder including the magnetic sensor according to the second embodiment of the present invention. A magnetic encoder 41 illustrated in Fig. 6 includes a rotating body 42, a magnetic sensor 43, and an encoder circuit 44. In the rotating magnet 44 configuring the rotating body 42, magnetic poles adjacent to each other in a circumferential direction are magnetized with the polarities thereof being different from each other, and the rotating magnet 44 includes a rotating magnet including twelve poles whose magnetization pitches are equal to one another. Hereinafter, it is assumed that the rotating magnet 44 rotates in an anticlockwise direction (arrow A direction) and arrows indicated by dotted lines indicate the directions of the magnetic field of the rotating magnet 44.

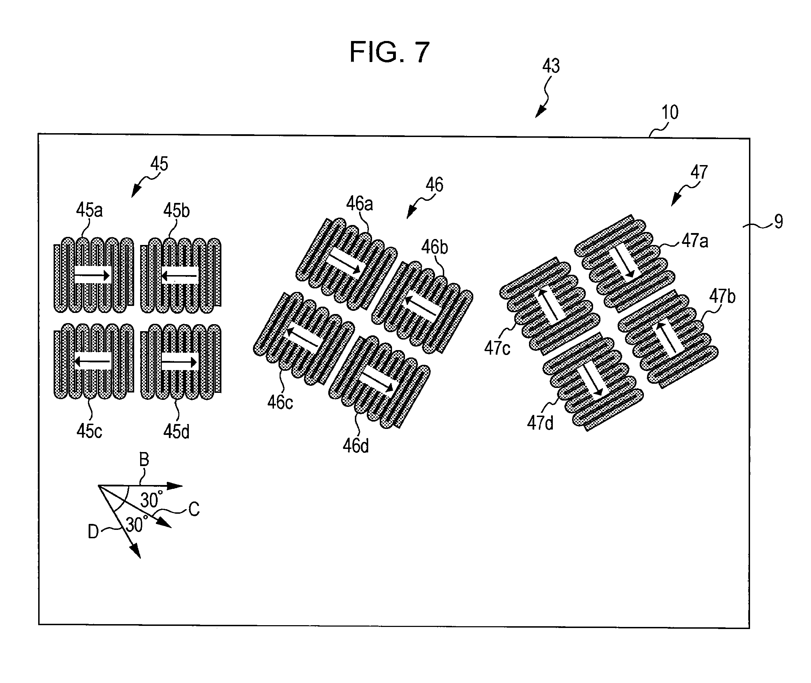

Fig. 7 is a plan pattern diagram illustrating the disposition relationship of the magnetic sensor 43. As illustrated in Fig. 7, in the the magnetic sensor 43, a plurality of (three in the present embodiment) magnetic detector elements 45, 46, and 47 having a same film configuration are mounted on the substrate 9 so as to be adjacent to each other, and these magnetic detector elements 45, 46, and 47 are accommodated within the single sensor package 10 in a state in which the sensitivity axis directions of the individual magnetic detector elements are shifted from each other by 30 degrees. In the same way as in the first embodiment, as the magnetic detector elements 45, 46, and 47, it is desirable to use a magnetoresistance effect element such as the GMR element, the TMR element, or the like, which has a high output and a high sensitivity characteristic.

The magnetic detector element 45 includes a bridge circuit in which four magnetoresistance effect elements 45a to 45d are bridge-connected. In the same way, the magnetic detector element 46 includes a bridge circuit in which four magnetoresistance effect elements 46a to 46d are bridge-connected, and the magnetic detector element 47 includes a bridge circuit in which four magnetoresistance effect elements 47a to 47d are bridge-connected. Each of the magnetoresistance effect elements 45, 46, and 47 is formed in a shape (meander shape) in which a plurality of belt-like elongated patterns (stripes), disposed so that the longitudinal directions thereof are parallel to one another, are folded. In each of the magnetoresistance effect elements 45, 46, and 47 formed in this meander shape, a sensitivity axis direction (Pin direction) is a direction (stripe width direction) perpendicular to the longitudinal direction (stripe longitudinal direction) of the elongated pattern. In addition, in the same way as in the first embodiment, it may be possible for each of the magnetoresistance effect elements 45, 46, and 47 to include the magnetic detection bridge circuit illustrated in Fig. 2(b).

The three magnetic detector elements 45, 46, and 47 configured in this way are disposed with the sensitivity axis directions of the individual magnetic detector elements 45, 46, and 47 being different (shifted) from each other so that the phases of the output signals output from the individual magnetic detector elements 45, 46, and 47 have a desired phase relationship with each other. In the present embodiment, within the sensor package 10, the sensitivity axis direction (arrow C direction) of the magnetic detector element 46 is disposed so as to be shifted by 30 degrees in one direction (the illustrated direction corresponds to an anticlockwise direction) in a same plane with respect to the sensitivity axis direction (arrow B direction) of the magnetic detector element 45, and the sensitivity axis direction (arrow D direction) of the magnetic detector element 47 is disposed so as to be shifted by 30 degrees in the same direction in a same plane with respect to the sensitivity axis direction (arrow C direction) of the magnetic detector element 46 (namely, shifted by 60 degrees in the same direction with respect to the sensitivity axis direction of the magnetic detector element 45). Accordingly, it is possible to obtain the output signals of the individual magnetic detector elements 45, 46, and 47 having a desired phase relationship with each other. In the present embodiment, it is possible to obtain output signals out of phase with each other by 30 degrees owing to the phase relationship between the output signals of the individual magnetic detector elements 45, 46, and 47.

On the basis of the phase shift between the output signals of the three magnetic detector elements 45, 46, and 47, the encoder circuit 4 detects the rotation of the rotating magnet 44. Specifically, the encoder circuit 4 acquires an output signal from the magnetic detector element 45 most strongly subjected to the influence of the flow of a magnetizing field (the direction of the magnetic field) associated with the rotation of the rotating magnet 44, and next acquires an output signal, out of phase with the phase of the former output signal (the output signal output from the magnetic detector element 45) by 30 degrees, from the magnetic detector element 46 most strongly subjected to the influence of the flow of a magnetizing field with the rotation of the rotating magnet 44. Furthermore, the encoder circuit 4 acquires an output signal, out of phase with the phase of the former output signal (the output signal output from the magnetic detector element 46) by 30 degrees, from the magnetic detector element 47 subjected to the influence of the flow of a magnetizing field with the rotation of the rotating magnet 44. In addition, from these three output signals having a phase difference of 30 degrees, the encoder circuit 4 detects the rotation of the rotating magnet 44.

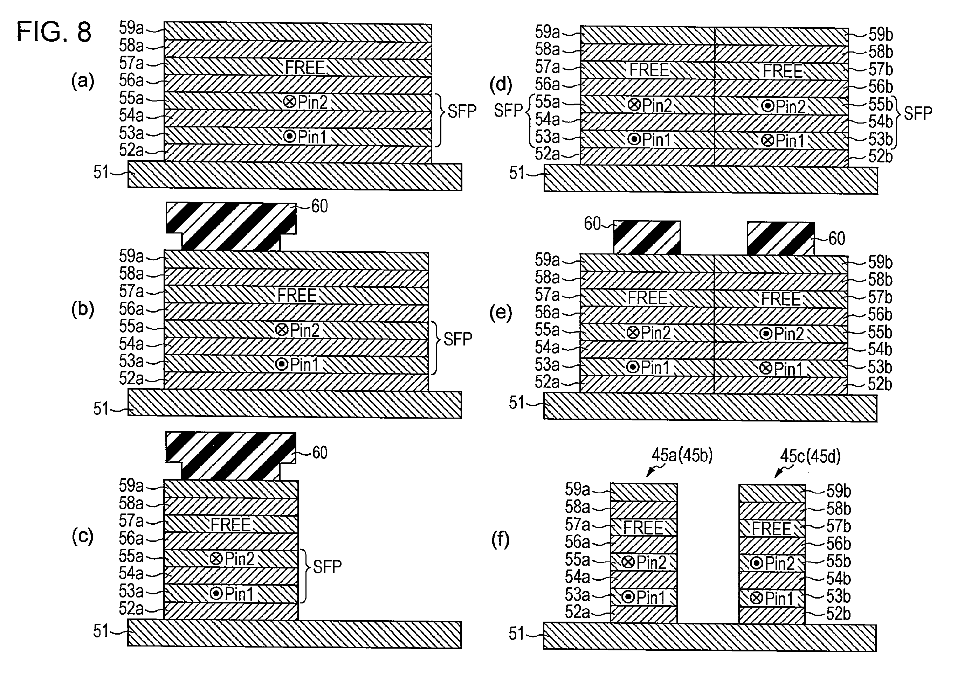

Next, using Fig. 8 to Fig. 10, the film configuration of the magnetoresistance effect element and the manufacturing method therefor will be described. In addition, since the film configuration of each of the magnetoresistance effect elements 45, 46, and 47 illustrated in Fig. 8(a) is the same as the film configuration of the magnetoresistance effect element 13 illustrated in Fig. 3(a), the detail description thereof will be omitted.

First, as illustrated in Fig. 8(a), on a substrate 51, a seed layer 52a, a first ferromagnetic film 53a, an antiparallel coupling film 54a, a second ferromagnetic film 55a, a nonmagnetic intermediate layer 56a, soft magnetic free layers (free magnetic layers) 57a and 58a, and a protective layer 59a are sequentially formed. During the film formation of the first ferromagnetic film 53a and the second ferromagnetic film 55a, a magnetizing field is applied in the stripe width direction of the meander shape. The applied-magnetizing field direction of the first ferromagnetic film 53a is a direction headed from the far side of the plane of paper to the near side thereof, and the applied-magnetizing field direction of the second ferromagnetic film 55a is a direction headed from the near side of the plane of paper to the far side thereof. In addition, during the film formation of the soft magnetic free layers (free magnetic layers) 57a and 58a, a magnetizing field is applied in the stripe longitudinal direction of the meander shape.

Next, as illustrated in Fig. 8(b), a resist layer 60 is formed on the protective layer 59a, and owing to photolithography and etching, the resist layer 60 is caused to remain on a region on the magnetoresistance effect element 45a (45b) side. Next, as illustrated in Fig. 8(c), owing to ion milling or the like, an exposed laminated film is removed, and the substrate 51 in a region in which the magnetoresistance effect element 45c (45d) is to be provided is caused to be exposed.

Next, as illustrated in Fig. 8(d), on the exposed substrate 51, a seed layer 52b, a first ferromagnetic film 53b, an antiparallel coupling film 54b, a second ferromagnetic film 55b, a nonmagnetic intermediate film 56b, soft magnetic free layers (free magnetic layers) 57b and 58b, and a protective layer 59b are sequentially formed. During the film formation of the first ferromagnetic film 53b and the second ferromagnetic film 55b, a magnetizing field is applied in the stripe width direction of the meander shape. The applied-magnetizing field direction of the first ferromagnetic film 53b is a direction headed from the near side of the plane of paper to the far side thereof, and the applied-magnetizing field direction of the second ferromagnetic film 55b is a direction headed from the far side of the plane of paper to the near side thereof. In addition, during the film formation of the soft magnetic free layers (free magnetic layers) 57b and 58b, a magnetizing field is applied in the stripe longitudinal direction of the meander shape.

Next, as illustrated in Fig. 8(e), the resist layer 60 is formed on the protective layers 59a and 59b, and owing to photolithography and etching, the resist layer 60 is caused to remain on the forming regions of the magnetoresistance effect elements 45a and 45c. Next, as illustrated in Fig. 8(f), owing to ion milling or the like, an exposed laminated film is removed, and the magnetoresistance effect elements 45a and 45c are formed. In addition, the above-mentioned processing is repeated in the same way, and the magnetoresistance effect elements 45b and 45d are formed.

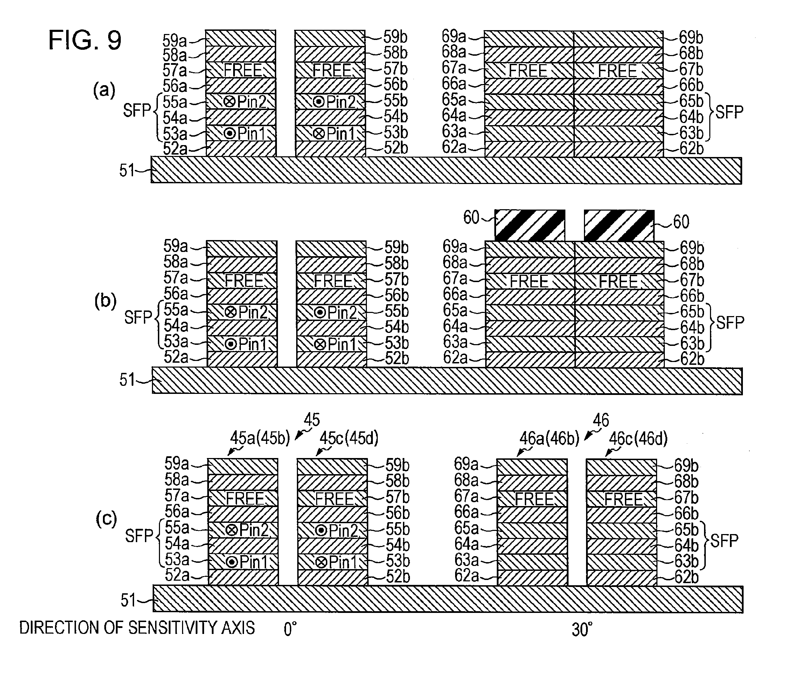

Next, in the same way as in Figs. 8(a) to 8(c), on the substrate 51, a seed layer 62a, a first ferromagnetic film 63a, an antiparallel coupling film 64a, a second ferromagnetic film 65a, a nonmagnetic intermediate layer 66a, soft magnetic free layers (free magnetic layers) 67a and 68a, and a protective layer 69a are sequentially formed (Fig. 9(a)). During the film formation of the first ferromagnetic film 63a and the second ferromagnetic film 65a, a magnetizing field is applied in the stripe width direction of the meander shape. The applied-magnetizing field direction of the first ferromagnetic film 63a is a direction out of phase by 30 degrees with the applied-magnetizing field direction of the first ferromagnetic film 53a in the magnetoresistance effect element 45a, and the applied-magnetizing field direction of the second ferromagnetic film 65a is a direction out of phase by 30 degrees with the applied-magnetizing field direction of the second ferromagnetic film 55a in the magnetoresistance effect element 45a. In addition, during the film formation of the soft magnetic free layers (free magnetic layers) 67a and 68a, a magnetizing field is applied in the stripe longitudinal direction of the meander shape. Next, the resist layer 60 is formed on the protective layer 69a, and owing to photolithography and etching, the resist layer 60 is caused to remain on a region on the magnetic detector element 46a (46b) side. Next, owing to ion milling or the like, an exposed laminated film is removed, and the substrate 51 in a region in which the magnetoresistance effect element 46c (46d) is to be provided is caused to be exposed.

Next, on the exposed substrate 51, a seed layer 62b, a first ferromagnetic film 63b, an antiparallel coupling film 64b, a second ferromagnetic film 65b, a nonmagnetic intermediate film 66b, soft magnetic free layers (free magnetic layers) 67b and 68b, and a protective layer 69b are sequentially formed (Fig. 9(a)). During the film formation of the first ferromagnetic film 63b and the second ferromagnetic film 65b, a magnetizing field is applied in the stripe width direction of the meander shape. The applied-magnetizing field direction of the first ferromagnetic film 63b is a direction out of phase by 30 degrees with the applied-magnetizing field direction of the first ferromagnetic film 53b in the magnetoresistance effect element 45c, and the applied-magnetizing field direction of the second ferromagnetic film 65b is a direction out of phase by 30 degrees with the applied-magnetizing field direction of the second ferromagnetic film 55b in the magnetoresistance effect element 45c. In addition, during the film formation of the soft magnetic free layers (free magnetic layers) 57b and 58b, a magnetizing field is applied in the stripe longitudinal direction of the meander shape.

Next, as illustrated in Fig. 9(b), the resist layer 60 is formed on the protective layers 69a and 69b, and owing to photolithography and etching, the resist layer 60 is caused to remain on the forming regions of the magnetoresistance effect elements 46a and 46c. Next, as illustrated in Fig. 9(c), owing to ion milling or the like, an exposed laminated film is removed, and the magnetoresistance effect elements 46a and 46c are formed. In addition, the above-mentioned processing is repeated in the same way, and the magnetoresistance effect elements 46b and 46d are formed.

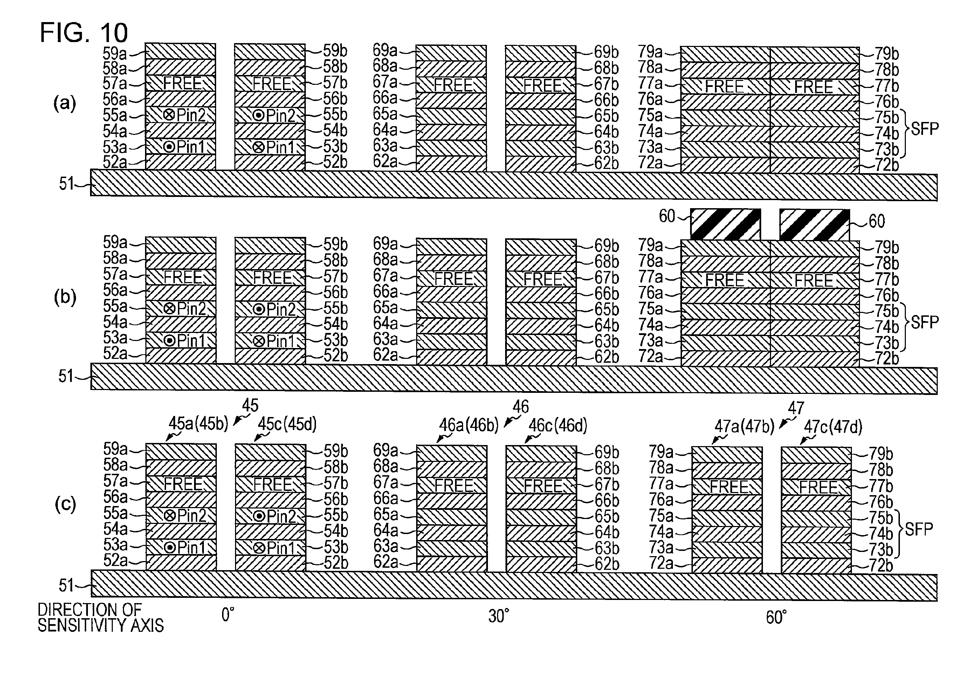

Next, in the same way as in Figs. 8(a) to 8(c), on the substrate 51, a seed layer 72a, a first ferromagnetic film 73a, an antiparallel coupling film 74a, a second ferromagnetic film 75a, a nonmagnetic intermediate layer 76a, soft magnetic free layers (free magnetic layers) 77a and 78a, and a protective layer 79a are sequentially formed (Fig. 10(a)). During the film formation of the first ferromagnetic film 73a and the second ferromagnetic film 75a, a magnetizing field is applied in the stripe width direction of the meander shape. The applied-magnetizing field direction of the first ferromagnetic film 73a is a direction out of phase by 30 degrees with the applied-magnetizing field direction of the first ferromagnetic film 63a in the magnetoresistance effect element 46a, and the applied-magnetizing field direction of the second ferromagnetic film 75a is a direction out of phase by 30 degrees with the applied-magnetizing field direction of the second ferromagnetic film 65a in the magnetoresistance effect element 46a. In addition, during the film formation of the soft magnetic free layers (free magnetic layers) 77a and 78a, a magnetizing field is applied in the stripe longitudinal direction of the meander shape. Next, the resist layer 60 is formed on the protective layer 79a, and owing to photolithography and etching, the resist layer 60 is caused to remain on a region on the magnetic detector element 47a (47b) side. Next, owing to ion milling or the like, an exposed laminated film is removed, and the substrate 51 in a region in which the magnetoresistance effect element 47c (47d) is to be provided is caused to be exposed.

Next, on the exposed substrate 51, a seed layer 72b, a first ferromagnetic film 73b, an antiparallel coupling film 74b, a second ferromagnetic film 75b, a nonmagnetic intermediate film 76b, soft magnetic free layers (free magnetic layers) 77b and 78b, and a protective layer 79b are sequentially formed (Fig. 10(a)). During the film formation of the first ferromagnetic film 73b and the second ferromagnetic film 75b, a magnetizing field is applied in the stripe width direction of the meander shape. The applied-magnetizing field direction of the first ferromagnetic film 73b is a direction out of phase by 30 degrees with the applied-magnetizing field direction of the first ferromagnetic film 63b in the magnetoresistance effect element 46c, and the applied-magnetizing field direction of the second ferromagnetic film 75b is a direction out of phase by 30 degrees with the applied-magnetizing field direction of the second ferromagnetic film 65b in the magnetoresistance effect element 46c. In addition, during the film formation of the soft magnetic free layers (free magnetic layers) 77b and 78b, a magnetizing field is applied in the stripe longitudinal direction of the meander shape.

Next, as illustrated in Fig. 10(b), the resist layer 60 is formed on the protective layers 79a and 79b, and owing to photolithography and etching, the resist layer 60 is caused to remain on the forming regions of the magnetoresistance effect elements 47a and 47c. Next, as illustrated in Fig. 10(c), owing to ion milling or the like, an exposed laminated film is removed, and the magnetoresistance effect elements 47a and 47c are formed. In addition, the above-mentioned processing is repeated in the same way, and the magnetoresistance effect elements 47b and 47d are formed.

In this way, the individual magnetic detector elements 45, 46, and 47 are manufactured in a state in which the sensitivity axis directions thereof are shifted from each other by 30 degrees. Namely, with reference to the sensitivity axis direction of the magnetic detector element 45, the sensitivity axis direction of the magnetic detector element 46 is formed so as to be a direction shifted from the sensitivity axis direction of the magnetic detector element 45 by 30 degrees, the sensitivity axis direction of the magnetic detector element 47 is formed so as to be a direction (direction shifted from the sensitivity axis direction of the magnetic detector element 45 by 60 degrees in a same direction) further shifted from the sensitivity axis direction of the magnetic detector element 46 by 30 degrees in the same direction (Fig. 10(c)).

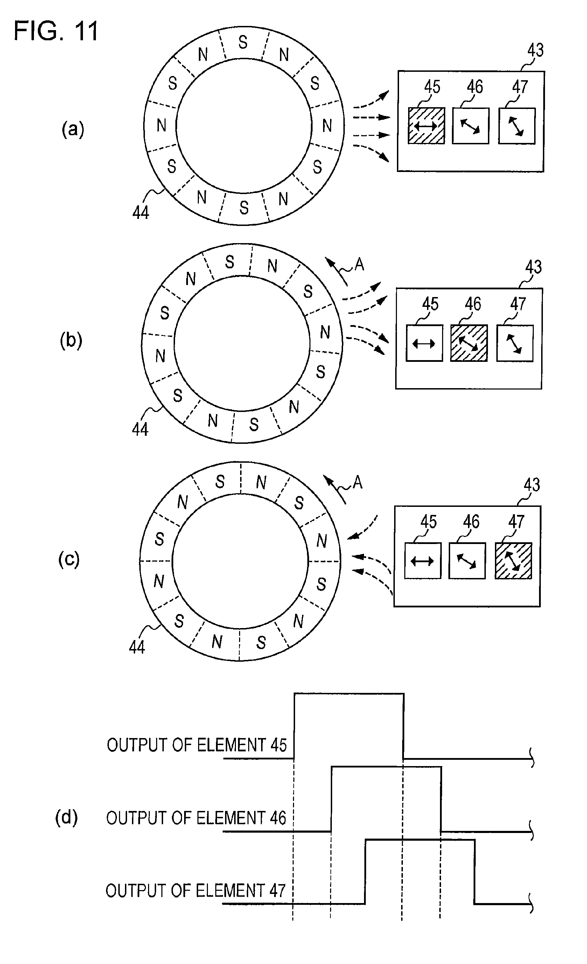

Next, using Fig. 11, the effect of the magnetic encoder 41 according to the present embodiment will be described. Fig. 11 is a pattern diagram for explaining the effect of the magnetic encoder 41 according to the present embodiment. Figs. 11(a), 11(b), and 11(c) illustrate a relationship between the direction of the magnetic field of the rotating magnet 44 and the sensitivity axis directions of the individual magnetic detector elements 45, 46, and 47, and Fig. 11(d) illustrates output signals output from the magnetic detector elements 45, 46, and 47 in Figs. 11(a), 11(b), and 11(c). Here, the magnetic sensor 43 will be cited as an example and described where, with reference to the sensitivity axis direction (the crosswise direction of the plane of paper) of the magnetic detector element 45 nearest to the rotating magnet 44, the sensitivity axis direction of the magnetic detector element 46 is disposed so as to be shifted from the sensitivity axis direction of the magnetic detector element 45 by 30 degrees in an anticlockwise fashion and the sensitivity axis direction of the magnetic detector element 47 is disposed so as to be shifted from the sensitivity axis direction of the magnetic detector element 46 by 30 degrees in an anticlockwise fashion. However, the magnetic sensor 43 is not limited to this disposition position and this disposition configuration of the magnetic sensor 43 (the magnetic detector elements 45, 46, and 47).

When the rotating magnet 44 is located at a position in Fig. 11(a), the magnetic detector element 45 having the sensitivity axis direction in approximately the same direction as the direction of a magnetic field is most strongly subjected to the influence of the magnetizing field, and the angle (magnetizing field angle) of the magnetization direction of the free magnetic layer with respect to the magnetization direction of the ferromagnetic fixed layer changes. On the basis of this change of the magnetizing field angle, an electrical resistance value changes, and an output signal based on the electrical resistance value according to this change is output to the encoder circuit 4 (Fig. 11(d)).

In addition, when the rotating magnet 44 has rotated from the position illustrated in Fig. 11(a) in an arrow A direction, the magnetic detector element 46 having the sensitivity axis direction out of phase with the sensitivity axis direction of the magnetic detector element 45 by 30 degrees is most strongly subjected to the influence of the magnetizing field flowing in the direction of the magnetic field, and the magnetizing field angle of the magnetization direction of the free magnetic layer with respect to the magnetization direction of the ferromagnetic fixed layer changes (Fig. 11(b)). On the basis of this change of the magnetizing field angle, an electrical resistance value changes, and an output signal based on the electrical resistance value according to this change is output to the encoder circuit 4 (Fig. 11(d)). At this time, an output signal output from the magnetic detector element 46 is put into a state in which the output signal is out of phase with an output signal output from the magnetic detector element 45 by 30 degrees.

Furthermore, when the rotating magnet 44 has rotated from the position illustrated in Fig. 11(b) in the arrow A direction, the magnetic detector element 47 having the sensitivity axis direction out of phase with the sensitivity axis direction of the magnetic detector element 46 by 30 degrees is most strongly subjected to the influence of the magnetizing field flowing in the direction of the magnetic field, and the magnetizing field angle of the magnetization direction of the free magnetic layer with respect to the magnetization direction of the ferromagnetic fixed layer changes (Fig. 11(c)). On the basis of this change of the magnetizing field angle, an electrical resistance value changes, and an output signal based on the electrical resistance value according to this change is output to the encoder circuit 4 (Fig. 11(d)). At this time, an output signal output from the magnetic detector element 47 is put into a state in which the output signal is out of phase with the output signal output from the magnetic detector element 46 by 30 degrees. Namely, in the encoder circuit 4, a three-phase output signal having a 30-degree phase difference between the magnetic detector elements 45, 46, and 47. In the encoder circuit 4, from the phase relationship of the output signal of the magnetic detector element 46, out of phase with the phase of the output signal from the magnetic detector element 45 by 30 degrees, the rotation direction of the rotating magnet 44 is detected, and from the phase relationship of the output signal of the magnetic detector element 47, out of phase with the phase of the output signal from the magnetic detector element 46 by 30 degrees, the rotation direction of the rotating magnet 44 is detected.

In this way, in the present embodiment, the sensitivity axis directions of the individual magnetic detector elements 45, 46, and 47 are disposed with being different (shifted) from each other by 30 degrees in the same direction so that the phases of the individual output signals have a desired phase relationship with each other. Therefore, even if the plural magnetic detector elements 45, 46, and 47 are accommodated within the single sensor package 10, it is possible to obtain the output signals of the individual magnetic detector elements 45, 46, and 47 having the desired phase relationship with each other without increasing the size of the sensor package 10, and hence it is possible to detect the rotation of the rotating magnet 44 with accuracy. Namely, from the output signal from the magnetic detector element 45, the output signal of the magnetic detector element 46 having a predetermined phase shift with respect to the output signal of the magnetic detector element 45, and the output signal of the magnetic detector element 47 having a predetermined phase shift with respect to the output signal of the magnetic detector element 46, it is possible to detect the rotation direction and the angular phase of the rotating magnet 44 with accuracy.

In addition, in the present embodiment, in order to obtain the plural output signals having the phase difference of 30 degrees, the sensitivity axis directions of the magnetic detector elements 45, 46, and 47 are disposed so as to be shifted from each other by 30 degrees. However, without being limited to this disposition configuration, it is possible to vary the sensitivity axis directions of the individual magnetic detector elements 45, 46, and 47 in response to an intended purpose to which the magnetic sensor 43 is applied. For example, if the magnetic detector elements 45, 46, and 47 are disposed so the sensitivity axis directions of the three magnetic detector elements 45, 46, and 47 are shifted from each other by 60 degrees or 120 degrees, it is possible to obtain a three-phase output signal having the phase difference of 60 degrees or 120 degrees.

It is possible to apply the magnetic sensor 43 configured in this way to the rotation control of a brushless motor used for a drive motor for a vehicle such as an electric vehicle, a hybrid vehicle, or the like or an electronic device or the like, for example. For example, owing to an output signal that is output from the magnetic sensor 43 and maintains a given phase difference, it is also possible to control the current of the stator coil of the brushless motor. In the rotation control of the brushless motor, three pairs of coils, out of phase with each other, for example, by 120 degrees, are disposed with respect to the magnetic pole of a rotating magnet, it is controlled with which polarity a current is supplied to each coil in response to the rotational position of the rotating magnet, and the rotating magnet is controlled so as to rotate with maximum attraction and maximum repulsion occurring. In this case, for example, in order to detect the position of the rotating magnet in three stages, a magnetic sensor with a three-phase output is used.

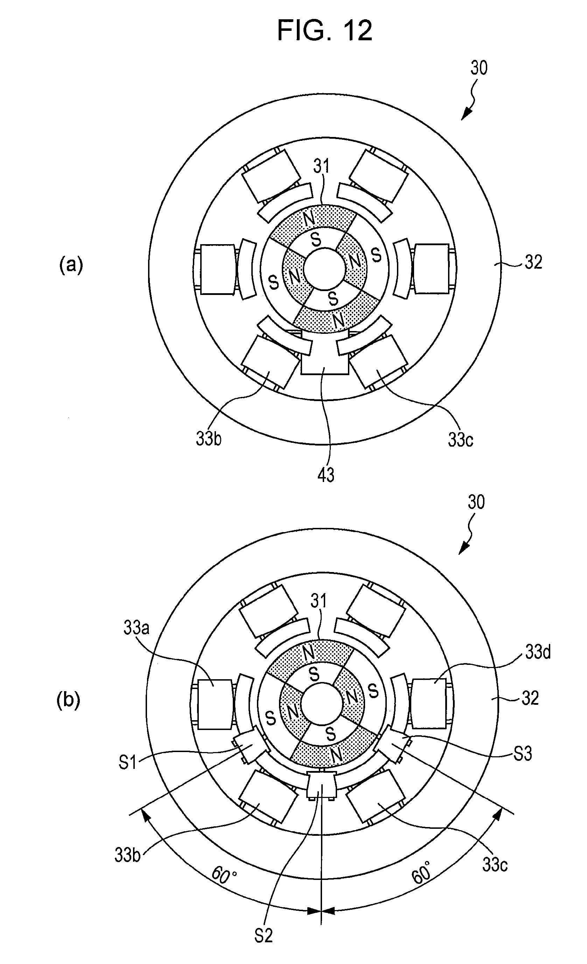

Fig. 12 is a pattern diagram illustrating an example of a brushless motor into which a magnetic sensor is applied. Fig. 12(a) illustrates a brushless motor into which a magnetic sensor according to the present embodiment is applied, and Fig. 12(b) illustrates a brushless motor into which a magnetic sensor according to a comparative example is applied. Here, a case will be cited as an example and described in which the magnetic sensor is attached to the brushless motor so that it is possible to obtain three output signals having the phase difference of 60 degrees from the magnetic sensor. A magnetic sensor 43 according to the present embodiment is a magnetic sensor where the three magnetic detector elements 45, 46, and 47 whose sensitivity axis directions are shifted by 60 degrees from each other in a same direction are accommodated within the single sensor package 10. On the other hand, the magnetic sensor according to the comparative example is a magnetic sensor where a single magnetic detector element is accommodated within a single sensor package and the three magnetic sensors S are used.

As illustrated in Fig. 12, a brushless motor 30 includes a rotatable rotor magnet 31 and a stator 32 provided in the outer circumference of the rotor magnet 31. A plurality of coils 33 are attached to the stator 32 at regular intervals in a circumferential direction (6 coils 33 are attached at intervals of 60 degrees) so as to face the outer circumference surface of the rotor magnet 31. In the rotor magnet 31, a north pole and a south pole are alternately magnetized with an equal pitch in a radial direction, and a north pole and a south pole are alternately magnetized with an equal pitch along a rotation direction.

In the case of the magnetic sensor according to the comparative example illustrated in Fig. 12(b), first a first magnetic sensor S1 is provided between predetermined coils 33a and 33b with being adjacent to the outer circumference of the rotor magnet 31. Next, a second magnetic sensor S2 is provided, with being adjacent to the outer circumference of the rotor magnet 31, between coils 33b and 33c adjacent to the coils 33a and 33b between which the first magnetic sensor S1 is fixedly set up, so that the sensitivity axis direction of the magnetic sensor S2 is shifted by 60 degrees with respect to the sensitivity axis direction of the first magnetic sensor S1. Furthermore, a third magnetic sensor S3 is provided, with being adjacent to the outer circumference of the rotor magnet 31, between coils 33c and 33d adjacent to the coils 33b and 33c between which the second magnetic sensor S2 is fixedly set up, so that the sensitivity axis direction of the magnetic sensor S3 is shifted by 60 degrees with respect to the sensitivity axis direction of the second magnetic sensor S2. In this way, in the case of the magnetic sensor according to the comparative example, it is necessary for the sensitivity axis directions of the remaining two magnetic sensors S2 and S3 to be individually shifted by 60 degrees from the sensitivity axis direction of the magnetic sensor S1 used as a reference, and it is necessary for the three magnetic sensors S1, S2, and S3 to be individually mounted with accuracy. Accordingly, when the mounting accuracy of the magnetic sensors S1, S2, and S3 vary, this variation influences an output signal from each of the magnetic sensors S1, S2, and S3, and there is a possibility that it is not possible to obtain a signal having a desired phase difference.

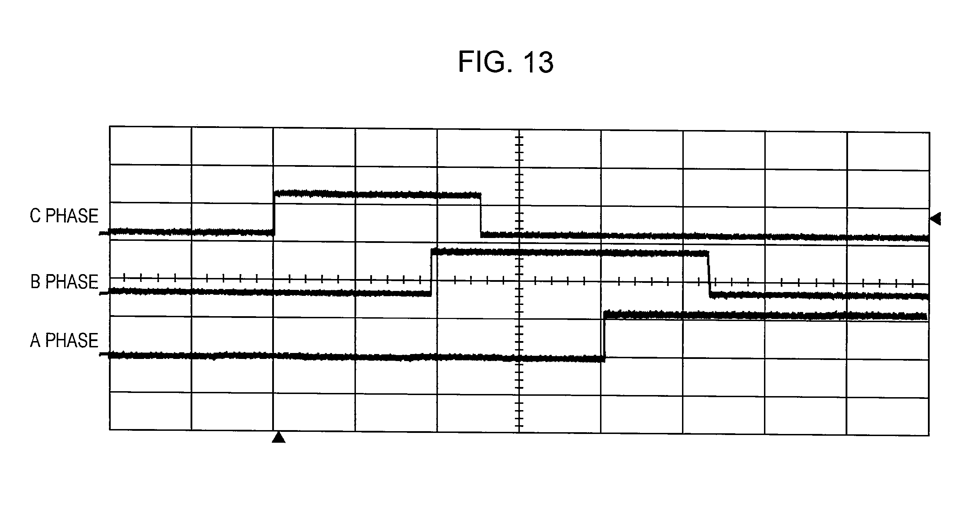

On the other hand, in the case of the magnetic sensor 43 according to the present embodiment illustrated in Fig. 12(a), since the magnetic sensor 43 has been accommodated within the single sensor package 10 in a state in which the sensitivity axis directions are shifted from each other by 60 degrees, it is only necessary to fixedly set up the magnetic sensor 43 between the two coils 33b and 33c so as to be adjacent to the outer circumference of the rotor magnet 31. Accordingly, in the case of the magnetic sensor 43 according to the present embodiment, it is possible to obtain a 3-phase output signal (A phase, B phase, and C phase outputs) having the phase difference of 60 degrees from the individual magnetic detector elements 45, 46, and 47 in the magnetic sensor 43 without being influenced by the mounting accuracy of the magnetic sensor 43 (Fig. 13).

In this way, compared with the magnetic sensor S according to the comparative example, it is possible for the magnetic sensor 43 according to the present embodiment to obtain a signal having a desired phase difference without being influenced by the mounting accuracy of the magnetic sensor. In addition, since, compared with the magnetic sensors S1, S2, and S3 according to the comparative example, it is only necessary to attach the single magnetic sensor 43, it is possible to reduce a process for attaching a magnetic sensor and it is possible to simply attach the magnetic sensor. Furthermore, it is possible to reduce the sensor number (parts count) of magnetic sensors. In addition, compared with a case in which a plurality of magnetic sensors are mounted, the possibility of an attachment position is improved, and it is possible to reduce the component size of a substrate or the like and commonalize the component shape of the substrate or the like.

### Embodiment

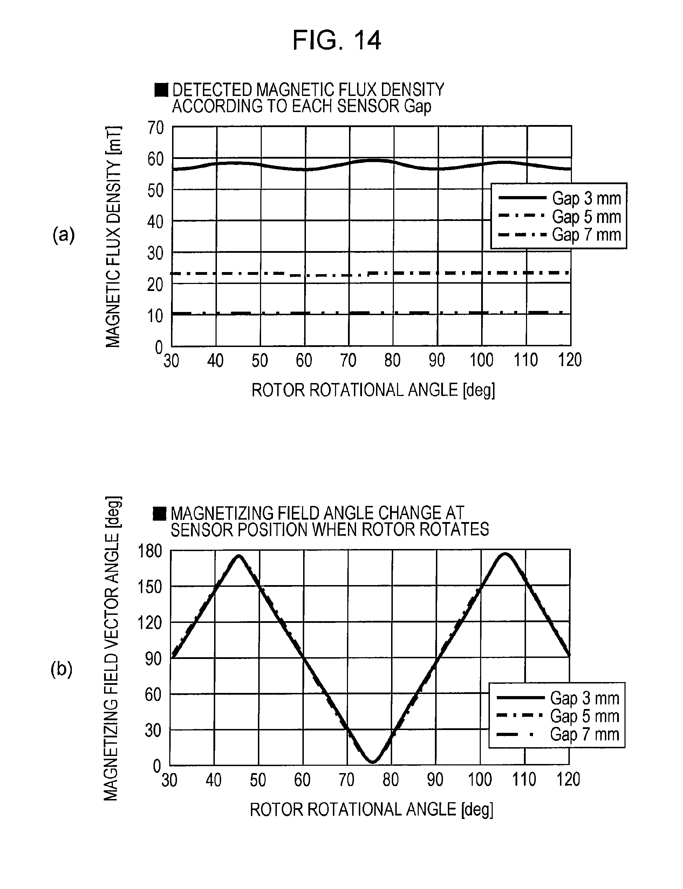

Next, the embodiment of the present invention will be described. The magnetic sensor 43 according to the embodiment has been configured by accommodating, within the single sensor package 10, the three magnetic detector elements 45, 46, and 47 whose sensitivity axis directions are shifted from each other by 60 degrees. In addition, the magnetic sensor 43 has been disposed so as to be adjacent to the outer circumference portion of the rotating magnet 44 including twelve poles whose magnetization pitches are equal to one another. As the rotating magnet 44, a sintered neodymium magnet has been used in which twelve poles are radial magnetized. As for a magnetic flux density in this magnetic sensor 43, the magnetic flux density increases with a decrease in a distance (Gap) from the outer circumference of the rotating magnet 44 to the magnetic sensor 43, and a magnetic flux density in each Gap is approximately constant even if the rotor rotational angle changes (Fig. 14(a)). On the other hand, the magnetizing field vector angle linearly corresponds to the rotor rotational angle in all Gaps (Fig. 14 (b)).

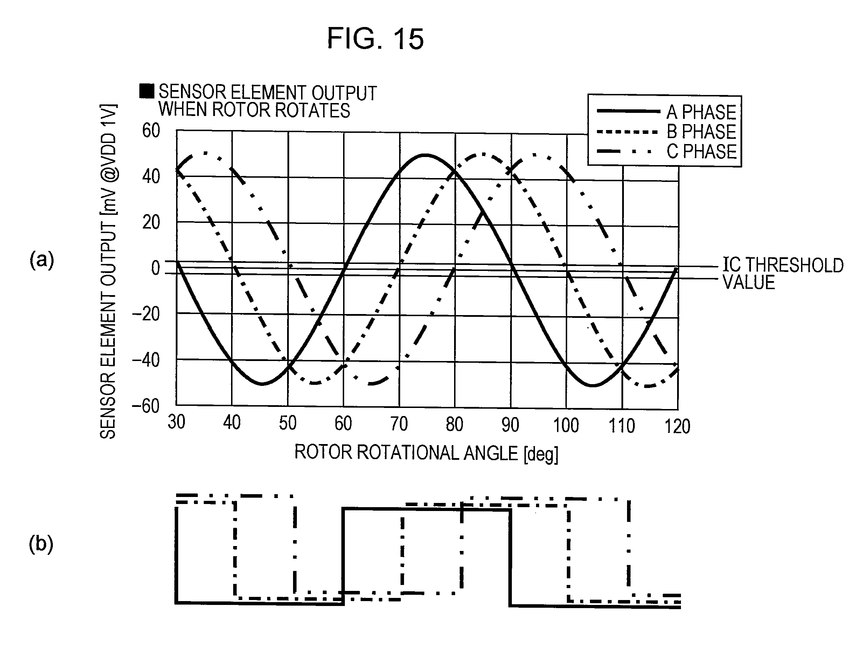

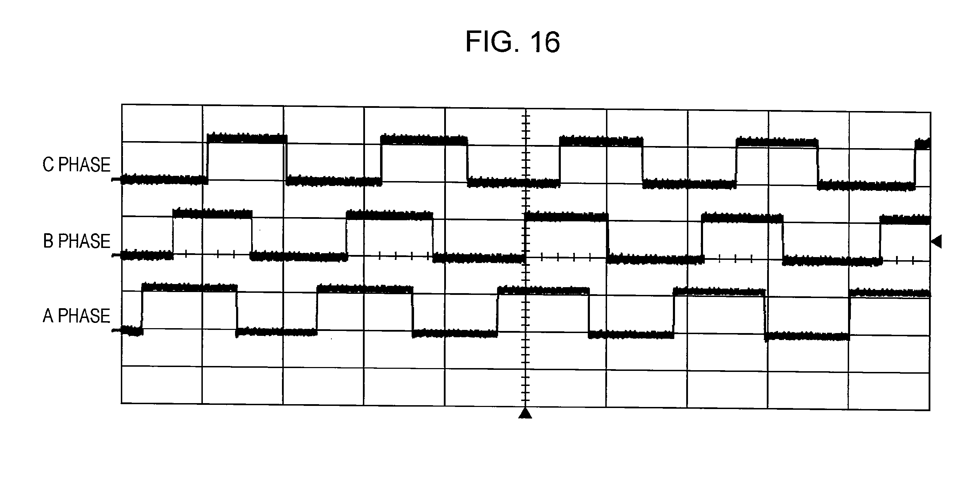

In the magnetic sensor 43 according to the present embodiment, the individual output signals (A phase, B phase, and C phase outputs) output from the magnetic detector elements 45, 46, and 47 are extracted in a state in which the output signals have the phase difference of 60 degrees (Fig. 15(a)), and these outputs from the individual magnetic detector elements are converted into ON/OFF digital signals on an IC to be output (Fig. 15(b)). As a result, as illustrated in Fig. 16, it has been possible to obtain the three-phase output having the phase difference of 60 degrees from the individual magnetic detector elements 45, 46, and 47 in the magnetic sensor 43.

On the other hand, the magnetic sensor according to the comparative example has been configured by accommodating the single magnetic detector element in the single sensor package, and three magnetic sensors configured in this way have been prepared. In addition, at positions adjacent to the outer circumference portion of the rotating magnet including twelve poles whose magnetization pitches are equal to one another, the three magnetic sensors have been disposed with the sensitivity axis directions of the magnetic detector elements in the individual magnetic sensors being shifted from each other by 30 degrees.

In addition, the embodiment disclosed at this time is an exemplification in all respects, and the present invention is not limited to this embodiment. The scope of the present invention is not indicated by the description of only the above-mentioned embodiment but indicated by the claims, and it is intended that all modifications within the scope of the claims or the meaning and the scope of the equivalents thereof are included.

### Industrial Applicability

A magnetic sensor according to the present invention has the advantageous effect of being capable of obtaining output signals from a plurality of magnetic detector elements, which have a desired phase relationship with each other, and detecting the rotation of a rotating magnet with accuracy, without the size of a single sensor package being increased, and is useful for the rotation control of a brushless motor used as a drive motor for a vehicle, an electronic device, or the like, for example.

The present application is based on Japanese Patent Application No. 2010-056157 filed on March 12, 2010. The entire content thereof is hereby incorporated.

## Claims

1. A magnetic sensor comprising:
first and second magnetic detector elements provided so as to face an outer circumference portion of a rotating magnet in which magnetic poles adjacent to each other in a circumferential direction are magnetized with polarities thereof being different from each other, wherein
the first and second magnetic detector elements are disposed in a single sensor package with sensitivity axis directions of the individual magnetic detector elements being different from each other so that phases of output signals output from the first and second magnetic detector elements have a desired phase relationship with each other.

2. The magnetic sensor according to Claim 1, wherein
the rotating magnet includes four poles whose magnetization pitches are equal to one another, and
a sensitivity axis direction of the other magnetic detector element is caused to be perpendicular to a sensitivity axis direction of one magnetic detector element in a same plane.

3. The magnetic sensor according to Claim 1, further comprising:
a third magnetic detector element provided so as to face the outer circumference portion of the rotating magnet, wherein
the first, second, and third magnetic detector elements are disposed in the single sensor package with sensitivity axis directions of the individual magnetic detector elements being different from each other so that phases of output signals output from the first, second, and third magnetic detector elements have a desired phase relationship with each other.

4. The magnetic sensor according to Claim 3, wherein
the first, second, and third magnetic detector elements are disposed so that the sensitivity axis directions of the individual magnetic detector elements are shifted from each other by 30 degrees, 60 degrees, or 120 degrees in a same plane.

5. The magnetic sensor according to any one of Claim 1 to Claim 4, wherein
the first, second, and third magnetic detector elements are magnetoresistance effect elements.

6. A magnetic encoder comprising:
a rotating magnet in which magnetic poles adjacent to each other in a circumferential direction are magnetized with polarities thereof being different from each other; and
a magnetic sensor including first and second magnetic detector elements provided so as to face an outer circumference portion of the rotating magnet, wherein
the first and second magnetic detector elements are disposed in a single sensor package with sensitivity axis directions of the individual magnetic detector elements being different from each other so that phases of output signals output from the first and second magnetic detector elements have a desired phase relationship with each other.

7. The magnetic encoder according to Claim 6, wherein
the magnetic sensor includes a third magnetic detector element provided so as to face the outer circumference portion of the rotating magnet, wherein
the first, second, and third magnetic detector elements are disposed in the single sensor package with sensitivity axis directions of the individual magnetic detector elements being different from each other so that phases of output signals output from the first, second, and third magnetic detector elements have a desired phase relationship with each other.

## Amended claims

### Amended claims under Art. 19.1 PCT

1. (Amended) A magnetic sensor comprising:
first and second magnetic detector elements provided so as to face an outer circumference portion of a rotating magnet in which magnetic poles adjacent to each other in a circumferential direction are magnetized with polarities thereof being different from each other, wherein
the first and second magnetic detector elements are formed on a same substrate and disposed in a single sensor package with sensitivity axis directions of the individual magnetic detector elements being different from each other so that phases of output signals output from the first and second magnetic detector elements have a desired phase relationship with each other.

2. The magnetic sensor according to Claim 1, wherein
the rotating magnet includes four poles whosemagnetization pitches are equal to one another, and
a sensitivity axis direction of the other magnetic detector element is caused to be perpendicular to a sensitivity axis direction of one magnetic detector element in a same plane.

3. (Amended) The magnetic sensor according to Claim 1, further comprising:
a third magnetic detector element provided so as to face the outer circumference portion of the rotating magnet, wherein
the first, second, and third magnetic detector elements are formed on a same substrate and disposed in the single sensor package with sensitivity axis directions of the individual magnetic detector elements being different from each other so that phases of output signals output from the first, second, and third magnetic detector elements have a desired phase relationship with each other.

4. The magnetic sensor according to Claim 3, wherein
the first, second, and third magnetic detector elements are disposed so that the sensitivity axis directions of the individual magnetic detector elements are shifted from each other by 30 degrees, 60 degrees, or 120 degrees in a same plane.

5. The magnetic sensor according to any one of Claim 1 to Claim 4, wherein
the first, second, and third magnetic detector elements are magnetoresistance effect elements.

6. (Amended) A magnetic encoder comprising:
a rotating magnet in which magnetic poles adjacent to each other in a circumferential direction are magnetized with polarities thereof being different from each other; and
a magnetic sensor including first and second magnetic detector elements provided so as to face an outer circumference portion of the rotating magnet, wherein
the first and second magnetic detector elements are formed on a same substrate and disposed in a single sensor package with sensitivity axis directions of the individual magnetic detector elements being different from each other so that phases of output signals output from the first and second magnetic detector elements have a desired phase relationship with each other.

7. (Amended) The magnetic encoder according to Claim 6, wherein
the magnetic sensor includes a third magnetic detectorelement provided so as to face the outer circumferenceportion of the rotating magnet, wherein
the first, second, and third magnetic detector elementsare formed on a same substrate and disposed in the single sensor package with sensitivity axis directions of the individual magnetic detector elements being different from each other so that phases of output signals output from the first, second, and third magnetic detector elements have a desired phase relationship with each other.
